# FASCICULE DE BREVET EUROPEEN

(11) **EP 2 617 129 B1**
(45) Date de publication et mention de la délivrance du brevet: **23.07.2014**
(21) Numéro de dépôt: 11752575.8
(22) Date de dépôt: 09.09.2011
(51) Int. Cl.: B81B 3/00, H02N 2/18, H02N 2/00, H03H 9/02, H03H 9/24

(54) **DISPOSITIF A POUTRE SUSPENDUE ET MOYENS DE DETECTION PIEZORESISTIVE DU DEPLACEMENT DE CELLE-CI**
VORRICHTUNG MIT FREIHÄNGENDEM TRÄGER UND PIEZORESISTIVE VORRICHTUNG ZUR VERLAGERUNGSERKENNUNG
SUSPENDED-BEAM DEVICE AND PIEZORESISTIVE MEANS FOR DETECTING THE DISPLACEMENT THEREOF

(30) Priorité: 13.09.2010 FR 1057249
(43) Date de publication de la demande: 24.07.2013
(73) Titulaire: Commissariat à l'Énergie Atomique et aux Énergies Alternatives, 75015 Paris (FR)
(72) Inventeur: HENTZ, Sébastien, F-38000 Grenoble (FR); ANDREUCCI, Philippe, F-38430 Moirans (FR); COLINET, Eric, F-38240 Meylan (FR); DURAFFOURG, Laurent, F-38500 Voiron (FR); LABARTHE, Sébastien, F-38500 Voiron (FR)
(74) Mandataire: Ilgart, Jean-Christophe
(86) Numéro de dépôt international: PCT/EP2011/065687
(87) Numéro de publication internationale: WO 2012/034951

(56) Documents cités:
- WO-A1-2009/066203
- WO-A1-2010/015963
- US-A1- 2008 314 148
- MILE E ET AL: "In-plane nanoelectromechanical resonators based on silicon nanowire piezoresistive detection", NANOTECHNOLOGY, IOP, BRISTOL, GB, vol. 21, no. 16, 23 avril 2010 (2010-04-23), page 165504, XP020174814, ISSN: 0957-4484 cité dans la demande

## Description

### DOMAINE TECHNIQUE

La présente invention concerne un dispositif comportant une poutre suspendue et des moyens de détection piézorésistive du déplacement de cette poutre.

Ce dernier peut être un dispositif résonant, auquel cas la poutre constitue un résonateur, ou un dispositif non résonant.

L'invention trouve des applications notamment dans le domaine des capteurs de type MEMS (pour « Micro-Electro-Mechanical Systems ») ou de type NEMS (pour « Nano-Electro-Mechanichal Systems »).

Elle s'applique par exemple aux capteurs non résonants, permettant de mesurer des efforts statiques ou quasi-statiques, mais surtout aux capteurs résonants, par exemple les capteurs de masse.

### ÉTAT DE LA TECHNIQUE ANTÉRIEURE

Aux échelles nanométriques, la question du choix de la transduction (notamment parmi les transductions capacitive, piézoélectrique et piézorésistive) reste ouverte.

Ce choix intervient dans la recherche de l'augmentation du gain de transduction d'un dispositif résonant à concevoir, c'est-à-dire le rapport entre l'amplitude du signal électrique de sortie de ce dispositif et l'amplitude de déplacement du résonateur que comporte le dispositif.

Dans le domaine des MEMS, on utilise classiquement des jauges piézorésistives, disposées sur une structure que l'on veut détecter, et formées de zones de silicium localement dopées.

Mais, dans le domaine des NEMS, il est quasiment impossible, avec les procédés de fabrication actuels, d'obtenir des jauges de silicium localement dopées qui soient suffisamment petites pour pouvoir être positionnées sur des structures de quelques dizaines de nanomètres de large, sans aucune contrainte résiduelle.

Et il est encore moins facile de réaliser un pont de Wheatstone comportant de telles jauges, du genre des ponts qui sont classiquement utilisés avec les capteurs résonants.

Néanmoins d'excellents gains ont été obtenus avec la transduction piézorésistive, que cette dernière utilise un matériau métallique en vue de la détection d'un mouvement hors plan, ou des jauges semiconductrices gravées en vue de la détection d'un mouvement dans le plan, comme cela est expliqué dans le document suivant auquel on se reportera :
**[1]** E. Mile et al., Nanotechnology, Vol. 21 Issue 16, pp. 165504 (2010).
   Un dispositif résonant à détection piézorésistive est également connu par le document suivant auquel on se reportera :
**[2]** US 2008/0314148, invention de P. Robert, correspondant à EP 2008965.

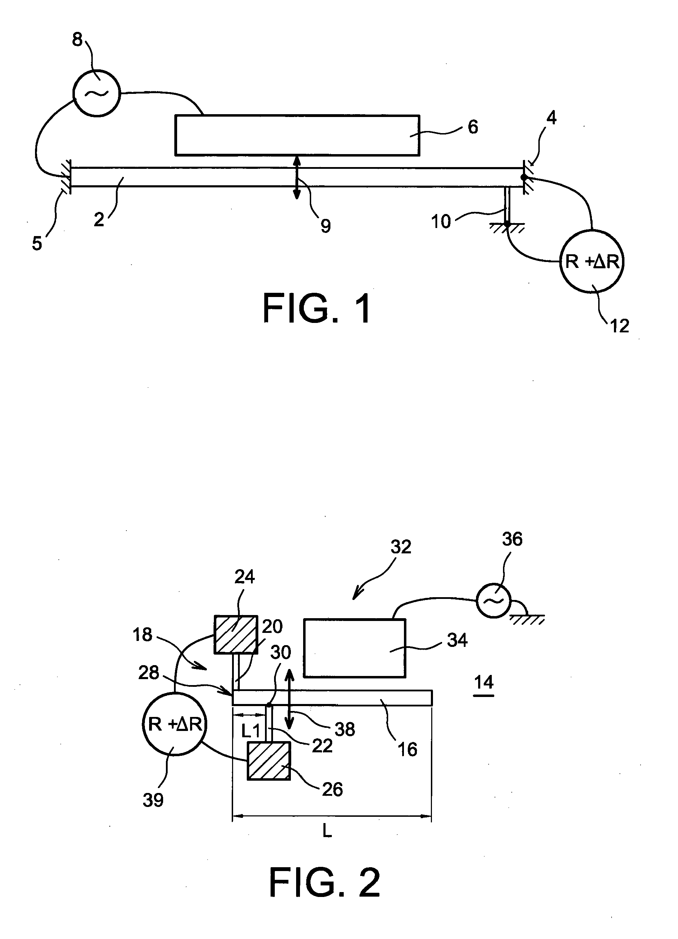

La figure 1 est une vue de dessus schématique d'un exemple du dispositif décrit dans ce document. I1 est formé sur un substrat et comprend :
- un résonateur 2, en forme de poutre, relié au substrat par au moins un encastrement 4 (en fait, dans l'exemple représenté, un deuxième encastrement 5 est prévu, comme on le voit),
- une électrode fixe 6 pour actionner le résonateur,
- une source de tension alternative 8, pour porter l'électrode à une tension alternative par rapport au résonateur, ce dernier vibrant alors parallèlement au plan de la surface du substrat, ce qui est symbolisé par la double flèche 9 de la figure 1,
- une jauge de contrainte suspendue 10, faite d'un matériau piézorésistif, et
- des moyens 12 de mesure de la contrainte subie par la jauge 10.

Cette dernière est reliée au résonateur 2 en un point qui est situé en dehors de l'encastrement 4. On dispose ainsi d'un bras de levier qui permet d'augmenter la contrainte subie par cette jauge.

Une telle solution est applicable à de nombreux NEMS dans lesquels le résonateur est relié au substrat par au moins un encastrement à proximité de la jauge de contrainte, ou jauge piézorésistive, en particulier lorsque le résonateur est une poutre encastrée libre (le mot « encastrement » désignant une zone de la surface de la poutre formant le résonateur, zone qui est directement reliée à une partie massive fixe et dont le déplacement par rapport au substrat est ainsi bloqué).

Le document [2] décrit une telle structure ainsi que des moyens d'actionnement et un schéma du montage utilisé pour détecter le mouvement du résonateur.

Dans le dispositif qui est décrit dans le document [1], la poutre formant le résonateur comprend, comme on vient de le voir, au moins un encastrement qui la relie au substrat. Ceci pose un problème.

En effet, une partie de la contrainte amplifiée par le bras de levier (résultant de la distance entre l'encastrement et le point en lequel la jauge de contrainte est reliée à la poutre) est perdue dans l'encastrement, alors qu'on souhaite évidemment maximiser la contrainte subie par la jauge piézorésistive, ou par les jauges piézorésistives lorsque le dispositif comporte plus d'une telle jauge.

De plus, l'une des sources d'amortissement du mouvement de la poutre résulte de cette perte de contrainte dans l'encastrement ; le facteur de qualité du dispositif résonant dont il est question dans le document [1] est ainsi dégradé.

### EXPOSÉ DE L'INVENTION

La présente invention a pour but de remédier aux inconvénients précédents.

Pour ce faire, la poutre que comporte le dispositif, objet de l'invention, n'est pas directement reliée au substrat par un encastrement : elle lui est reliée par l'intermédiaire des moyens de détection piézorésistive permettant de détecter le mouvement de la poutre.

De façon précise, la présente invention a pour objet un dispositif à poutre suspendue et moyens de détection piézorésistive du déplacement de la poutre, le dispositif comprenant :
- un support comportant une surface sensiblement plane,
- une poutre qui est suspendue vis-à-vis du support et apte à se déplacer parallèlement au plan de la surface du support, et
- des moyens de détection du déplacement de la poutre, comprenant au moins deux jauges de contrainte piézorésistives sensiblement rectilignes, suspendues vis-à-vis du support, les deux jauges de contrainte n'étant pas dans le prolongement l'une de l'autre,
dans lequel la poutre est suspendue vis-à-vis du support par l'intermédiaire des moyens de détection et n'est ainsi pas directement ancrée au support,
caractérisé en ce que lesdites au moins deux jauges de contrainte sont respectivement situées sur deux faces latérales opposées de la poutre.

Certes le document WO 2010/015963 décrit un transducteur électromécanique comprenant une poutre qui est suspendue à un support par l'intermédiaire de deux jauges de contraintes ; mais ces deux jauges sont placées du même côté de la poutre.

Avec une telle disposition, les deux jauges ne peuvent être identiques : si elles l'étaient, cela annulerait le signal piézorésistif. De plus, l'une des deux jauges doit être bien plus large que l'autre (auquel cas elle devient très rigide et l'on perd l'intérêt d'une suspension indirecte par l'intermédiaire des moyens de détection) ou alors les deux jauges doivent être localement dopées différemment l'une de l'autre. Or, comme on l'a mentionné plus haut, il est difficile d'effectuer des dopages locaux à des échelles nanométriques.

Le dispositif, objet de l'invention, remédie à ces inconvénients : dans ce dispositif, les deux jauges sont respectivement placées de part et d'autre de la poutre ; cela permet d'utiliser un dopage uniforme identique pour les deux jauges et/ou d'utiliser des jauges identiques, et donc aussi étroites l'une que l'autre, et de maximiser le signal de détection.

Selon un mode de réalisation particulier de l'invention, chaque jauge de contrainte comprend un empilement comportant au moins un matériau piézorésistif.

Selon un mode de réalisation particulier du dispositif, objet de l'invention, la poutre constitue un résonateur et le dispositif comprend en outre des moyens d'actionnement de la poutre.

Ces moyens d'actionnement de la poutre sont par exemple de type électrostatique.

La poutre peut avoir une section transversale constante ou, au contraire, non constante.

Selon un mode de réalisation particulier de l'invention, les deux extrémités de la poutre sont libres et sont ainsi aptes à se déplacer parallèlement au plan de la surface du support, et les jauges de contrainte sont espacées de ces deux extrémités.

Selon un mode de réalisation particulier, le dispositif comprend deux groupes d'au moins deux jauges de contrainte, et ces deux groupes sont respectivement situés sur deux faces latérales opposées de la poutre.

Dans l'invention, au moins l'une des jauges de contrainte peut être élastique.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue de dessus schématique d'un dispositif connu, à détection piézorésistive, et a déjà été décrite,
- la figure 2 est une vue de dessus schématique d'un mode de réalisation particulier du dispositif, objet de l'invention,
- la figure 3 est une vue de dessus schématique d'un autre mode de réalisation particulier, utilisant une poutre dont les extrémités sont libres,
- la figure 4 est une vue de dessus schématique d'une variante du dispositif de figure 3,
- la figure 5 est une vue de dessus schématique d'un autre exemple de l'invention, dans lequel la poutre a une section transversale non constante,
- la figure 6 est une vue de dessus schématique d'un autre exemple de l'invention, utilisant des jauges piézorésistives élastiques,
- la figure 7 est une vue de dessus schématique d'un dispositif non résonant, conforme à l'invention,
- les figures 8A à 8C illustrent schématiquement diverses étapes d'un procédé de fabrication d'un dispositif conforme à l'invention, et
- les figures 9A à 9D illustrent schématiquement diverses étapes d'un autre procédé de fabrication d'un dispositif conforme à l'invention.

### EXPOSÉ DÉTAILLÉ DE MODES DE RÉALISATION PARTICULIERS

La figure 2 est une vue de dessus schématique d'un mode de réalisation particulier du dispositif, objet de l'invention.

Le dispositif représenté sur cette figure comprend :
- un support 14, ou substrat, dont la surface est sensiblement plane,
- une poutre 16 dont la section transversale est constante et qui est suspendue vis-à-vis du support 14 et apte à se déplacer parallèlement au plan de la surface du support, et
- des moyens 18 de détection du déplacement de la poutre.

Dans l'exemple représenté sur la figure 2, ces moyens de détection 18 comprennent deux jauges de contrainte piézorésistives 20 et 22. Ces deux jauges sont en forme de poutre et sont donc sensiblement rectilignes. De plus, elles sont suspendues vis-à-vis du substrat 14. Chaque jauge de contrainte peut être faite d'un matériau piézorésistif ou peut comprendre un empilement comportant au moins un matériau piézorésistif.

Conformément à l'invention, la poutre 16 est suspendue vis-à-vis du support 16 par l'intermédiaire des moyens de détection 18 et n'est ainsi pas directement ancrée au support 14.

Les moyens de détection comprennent des ancrages 24 et 26 par l'intermédiaire desquels les jauges piézorésistives 20 et 22 sont respectivement fixées au support 14.

Comme on le voit, les deux jauges 20 et 22 sont respectivement situées sur deux faces latérales opposées de la poutre 16 et ne sont pas dans le prolongement l'une de l'autre : elles ne sont pas alignées.

Plus précisément, les deux jauges 20 et 22 sont toutes deux disposées perpendiculairement à la poutre 16 (et parallèlement à la surface du support 14) ; une extrémité de la jauge 20 se trouve en une extrémité 28 de la poutre 16, tandis que son autre extrémité est fixée à l'ancrage 24 ; et une extrémité de la jauge 22 se trouve en un point 30 de la poutre 16, espacé de l'extrémité 28 de celle-ci, tandis que l'autre extrémité de la jauge 22 est fixée à l'ancrage 26.

Dans l'exemple représenté sur la figure 2, la poutre 16 constitue un résonateur, de sorte que le dispositif est résonant. Dans ce cas, ce dispositif comprend en outre des moyens 32 d'actionnement de la poutre 16. Dans l'exemple, ces moyens d'actionnement sont de type électrostatique et comprennent une électrode 34 qui est fixée au support 14.

Une source de tension alternative 36 est prévue pour porter l'électrode 14 à une tension alternative par rapport à la poutre 16. Lorsque cette dernière est ainsi excitée, elle vibre parallèlement au plan de la surface du support 14, ce que l'on a symbolisé par la double flèche 38 sur la figure 2.

Pour exciter la résonance de la poutre 16, on peut utiliser d'autres moyens que des moyens électrostatiques, par exemple des moyens piézoélectriques, thermiques ou électromagnétiques.

La différence de conception entre le dispositif, objet de l'invention, par exemple le dispositif représenté sur la figure 2, et le dispositif qui est décrit dans le document [1], ne change rien à la méthode de lecture du dispositif : dans la présente invention, il s'agit toujours de lire la variation de la résistance des jauges piézorésistives.

Dans la présente invention, bien qu'on ait modifié la structure mécanique cette lecture est tout de même possible en connectant des moyens de lecture 39, aux ancrages 24 et 26 des jauges 20 et 22. Ces ancrages 24 et 26 constituent donc aussi des connexions électriquement conductrices. Il en est d'ailleurs de même dans tous les exemples donnés par la suite, pour les deux ancrages entre lesquels on connecte les moyens de lecture.

On lit donc la variation de résistance des jauges, de façon classique, entre les deux ancrages servant de connexions électriques. Cette lecture peut être faite :
- de façon directe,
- ou à l'aide d'un amplificateur synchrone (en anglais, *lock-in amplifier*),
- ou à l'aide d'un pont de Wheatstone (voir le document [1]-),
- ou par une technique plus sophistiquée, comme cela est expliqué dans le document [2] auquel on se reportera.

Pour que les variations de résistance des jauges ne se compensent pas, il faut qu'elles aient le même signe. C'est la raison pour laquelle on place les jauges 20 et 22 de part et d'autre de la poutre 16 dans le cas de la figure 2.

Dans le cas particulier de cette figure 2, si les jauges 20 et 22 étaient d'un même côté de la poutre 16, compte tenu de leurs positions respectives le long de celle-ci, l'une serait étirée et l'autre comprimée lors d'un mouvement de la poutre 16, et leurs variations de résistance respectives seraient opposées.

De plus, la dimension des jauges doit être choisie afin d'aboutir au meilleur compromis possible entre le bruit de Johnson engendré par chaque jauge - ce bruit est proportionnel à la résistance de cette jauge - et la contrainte subie par cette dernière, contrainte qui est inversement proportionnelle à la section transversale de la jauge.

On choisit donc, au premier ordre, des jauges qui sont très courtes et ont une section transversale la plus faible possible.

Leur position relative est également choisie afin de maximiser les contraintes subies par ces jauges. Cette position dépend donc du mode propre de fonctionnement choisi.

Par exemple, dans le cas de la figure 2, pour le mode de résonance appelé « mode 1 », on peut estimer que la position optimale est telle que la distance L1 entre l'extrémité 28 de la poutre 16 et le point 30 soit de l'ordre de 10% de la longueur L de la poutre 16.

Le principe de l'invention, selon lequel la poutre est suspendue vis-à-vis du support par l'intermédiaire des moyens de détection, s'applique aussi à une poutre dont les conditions aux limites sont dites « libre-libre », c'est-à-dire au cas où les deux extrémités de la poutre sont libres : elles sont aptes à se déplacer parallèlement au plan de la surface du support.

Dans ce cas, les jauges piézorésistives sont espacées des deux extrémités de la poutre.

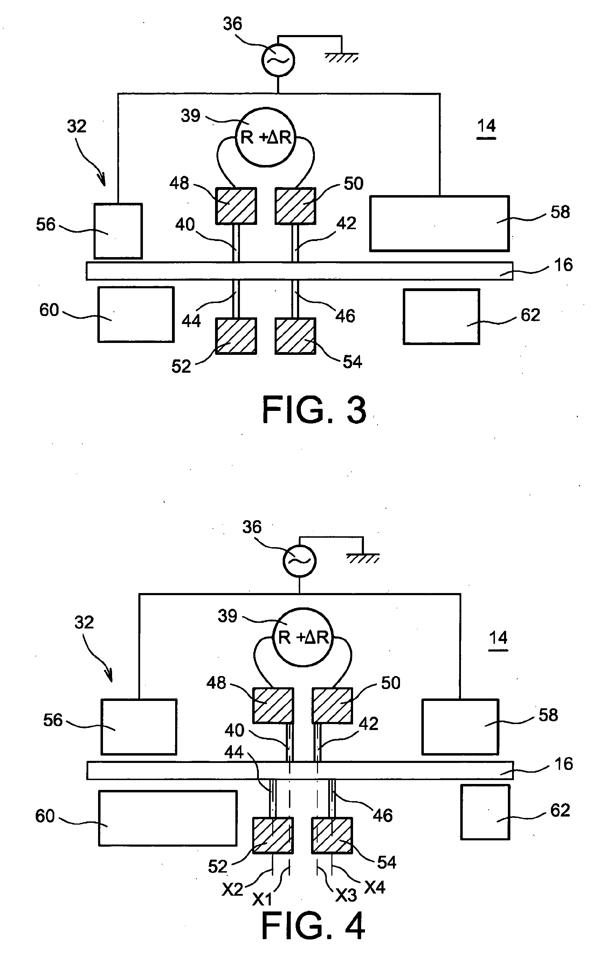

La figure 3 est une vue de dessus schématique d'un exemple de l'invention, dans lequel les deux extrémités de la poutre 16 sont libres.

Dans cet exemple, le dispositif comprend quatre jauges piézorésistives 40, 42, 44 et 46. Comme on le voit, les jauges 40 et 42 sont situées sur une face latérale de la poutre 16 et les jauges 44 et 46 sont situées sur la face latérale opposée. Les ancrages des jauges 40, 42, 44 et 46 ont respectivement les références 48, 50, 52 et 54.

Dans l'exemple de la figure 3, les moyens 32 d'actionnement de la poutre 16 comprennent quatre électrodes 56, 58, 60 et 62. Comme on le voit, les deux électrodes 56 et 58 sont du même côté de la poutre 16 que les jauges 40 et 42 ; et les deux électrodes 60 et 62 sont de l'autre côté, comme les jauges 44 et 46.

De plus, dans l'exemple de la figure 3, les jauges 40 et 44 sont sensiblement dans le prolongement l'une de l'autre et il en est de même pour les jauges 42 et 46. Et les électrodes 56 et 60 sont toutes deux en regard d'une extrémité de la poutre 16, tandis que les électrodes 58 et 62 sont toutes deux en regard de l'autre extrémité de la poutre 16.

Dans le dispositif représenté sur la figure 3, la source 36 est prévue pour exciter les deux électrodes 56 et 58 ; et les moyens de lecture 39 sont connectés entre les ancrages 48 et 50 (qui constituent alors également des connexions électriques).

Bien entendu, la source 36 peut être connectée différemment et l'on peut même utiliser plusieurs sources. Et la connexion des moyens de lecture dépend de la connexion des sources.

Par exemple, au lieu d'être connectée aux électrodes 56 et 58, la source 36 pourrait être connectée, d'une part, à l'électrode 58 et, d'autre part, à l'électrode 62 par l'intermédiaire d'un déphaseur à 180°. Ou l'on pourrait utiliser deux sources d'excitation, l'une connectée à l'électrode 56 et l'autre à l'électrode 60.

De même, au lieu de connecter les moyens de lecture 39 entre les ancrages 48 et 50, ils pourraient être connectés entre les ancrages 52 et 54. On pourrait même connecter des moyens de lecture entre les ancrages 48 et 50 et connecter d'autres moyens de lecture entre les ancrages 52 et 54. On reviendra sur cette question par la suite.

La configuration dans laquelle les deux extrémités de la poutre 16 sont libres présente un grand nombre d'avantages qui sont mentionnés ci-après.
1. Cette configuration permet toujours la lecture de la variation de résistance des jauges ;
2. Cette configuration permet aussi de profiter d'un effet de bras de levier si les jauges sont relativement proches l'une de l'autre, par rapport à la longueur totale de la poutre ;
3. Comme dans tous les autres cas, on peut utiliser une ou plusieurs électrodes d'actionnement électrostatique ; cela permet de favoriser certains modes de résonance privilégiés de la structure, voire de découpler deux harmoniques d'actionnement à des fréquences différentes.
4. On peut choisir d'effectuer la lecture de la variation de résistance entre différents ancrages des jauges (ces ancrages servant aussi de connections électriques), suivant le mode de résonance utilisé pour la structure.

Par exemple pour le mode 1 (qui est symétrique), on peut effectuer une lecture de résistance entre les ancrages 48 et 50 et/ou entre les ancrages 52 et 54.

Pour un mode antisymétrique, on utilise plutôt les ancrages 48 et 54 et/ou les ancrages 50 et 52.

On peut également effectuer une mesure différentielle en polarisant l'ancrage 50 avec une tension +V1 et l'ancrage 54 avec une tension -V1, et en mesurant par exemple un courant sur les ancrages 48 et 52 que l'on connecte alors ensemble, par exemple par une technique appelée « bonding ».

Les jauges qui sont situées de part et d'autre de la poutre peuvent également être axialement décalées deux à deux. Un exemple de cette possibilité est schématiquement illustré par la figure 4.

Dans le dispositif représenté sur cette figure 4, les jauges 40 et 44 ne sont plus dans le prolongement l'une de l'autre : leurs axes respectifs X1 et X2 ne sont plus confondus ; de même, les axes respectifs X3 et X4 des jauges 42 et 46 ne sont plus confondus (contrairement au cas de la figure 3). Dans l'exemple de la figure 4, comme on le voit, les axes X1 et X3 sont dans la zone délimitée par les axes X2 et X4.

Dans l'invention, on peut également placer les jauges aux extrémités de la poutre ; et les jauges peuvent alors être axialement alignées ou non.

De plus, au lieu d'avoir une section transversale constante, la poutre peut avoir une section transversale non constante.

Alors, dans le cas où les jauges sont placées aux extrémités de la poutre et lorsque cette poutre constitue un résonateur, un autre avantage du dispositif (qui est alors résonant) réside dans le fait que l'amplitude de vibration maximale de la poutre, avant d'atteindre le régime non-linéaire, est plus importante que celle d'un résonateur de type encastré-encastré, c'est-à-dire d'une poutre dont les deux extrémités sont ancrées au support.

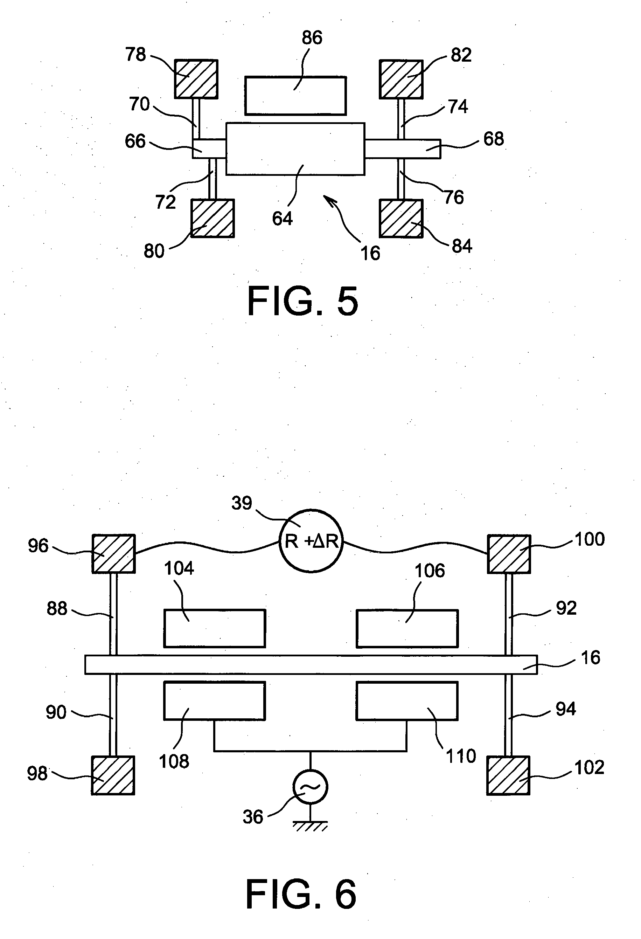

La figure 5 est une vue de dessus schématique et partielle d'un exemple de l'invention dans lequel la section transversale de la poutre 16 n'est pas constante. Dans cet exemple, la poutre 16 comporte, comme on le voit, une partie centrale 64 et, de part et d'autre de celle-ci, deux parties d'extrémité 66 et 68 qui sont alignées l'une avec l'autre.

De plus, le dispositif de la figure 5 comprend deux jauges piézorésistives 70 et 72 axialement décalées, reliées à la partie d'extrémité 66, et deux jauges piézorésistives 74 et 76 dont les axes sont confondus et qui sont reliées à la partie d'extrémité 68. La poutre 16 est ainsi suspendue par l'intermédiaire des jauges 70, 72, 74 et 76. Les ancrages des jauges 70, 72, 74 et 76 ont respectivement les références 78, 80, 82 et 84.

Le dispositif de la figure 5 ne comporte qu'une électrode pour actionner la poutre 16. La source d'excitation et les moyens de lecture ne sont pas représentés.

Dans l'invention, au moins l'une des jauges piézorésistives peut être élastique. Ceci permet de repousser le seuil d'apparition du régime non-linéaire de déplacement de la poutre.

Un exemple de cette possibilité est schématiquement illustré par la figure 6. On y voit la poutre 16, pourvue de quatre jauges piézorésistives 88, 90, 92 et 94 dont les ancrages respectifs ont les références 96, 98, 100 et 102.

Les jauges 88 et 90 ont des axes confondus et sont de part et d'autre d'une même extrémité de la poutre. De même, les jauges 92 et 94 ont des axes confondus et sont de part et d'autre de l'autre extrémité de la poutre 16, comme on le voit.

Dans l'exemple de la figure 6, on utilise quatre électrodes pour actionner la poutre 16, à savoir deux électrodes 104 et 106 qui sont du même côté que les jauges 88 et 92, et deux autres électrodes 108 et 110 qui sont du même côté que les jauges 90 et 94, comme on le voit.

Parmi les jauges axialement alignées, deux sont élastiques, par exemple les jauges 88 et 90. En variante, les quatre jauges 88, 90, 92 et 94 sont élastiques.

Les moyens 39 de lecture du dispositif sont par exemple connectés entre les ancrages 96 et 100 et la source 36 excite par exemple les électrodes 108 et 110.

On précise que pour qu'une jauge soit élastique, il suffit que sa longueur soit bien plus importante que sa largeur, par exemple au moins 10 fois plus grande que sa largeur.

Dans les exemples de l'invention, que l'on a donnés jusqu'à présent, le dispositif était résonant. Mais l'invention n'est pas limitée à ce cas : un dispositif conforme à l'invention peut aussi être non résonant.

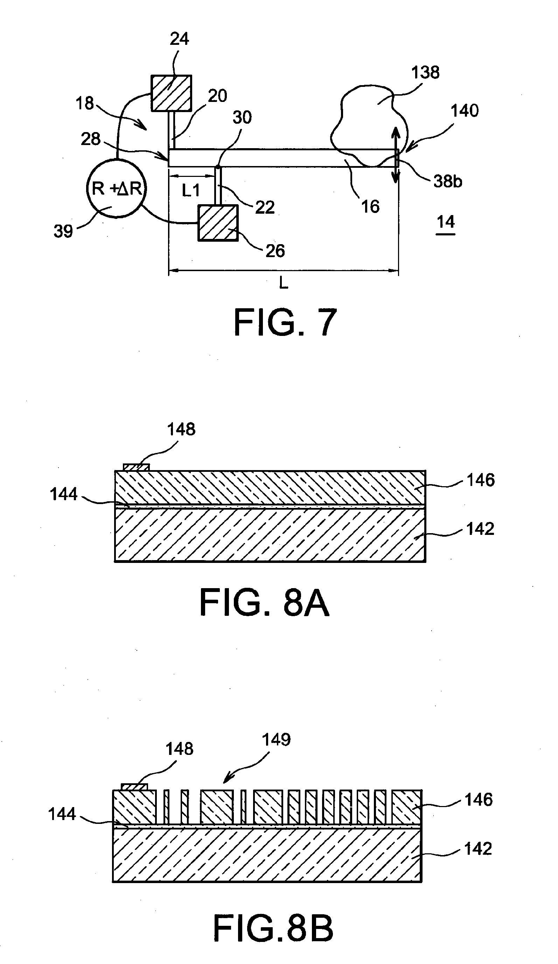

Un exemple d'un tel dispositif est schématiquement illustré par la figure 7. Comme on le voit, il est identique au dispositif représenté sur la figure 2 excepté qu'il ne comporte aucun moyen d'actionnement : dans la figure 7, l'électrode 34 (et la source 32) de la figure 2 n'existent pas. On a conservé les mêmes références pour les éléments de la figure 2 que l'on retrouve dans la figure 7.

Le dispositif de la figure 7 peut servir à mesurer des efforts statiques ou quasi-statiques : on peut par exemple mesurer la force exercée par une cellule 138 reposant en partie sur le substrat 14 et en partie sur l'extrémité libre 140 de la poutre 16. Cette cellule provoque un déplacement statique ou quasi-statique de la poutre 16 dans une direction transversale 38b.

Les jauges piézorésistives utilisées dans l'invention peuvent être en silicium dopé. Elles peuvent aussi être métalliques ; pour ce faire, on peut doper très fortement le silicium jusqu'à l'amorphisation de celui-ci. On peut aussi utiliser des jauges faites d'un composé métal-silicium tel que NiSi ou PtSi par exemple.

Il est également possible d'obtenir les jauges à partir d'éléments de silicium sur lesquels on dépose une couche métallique, par exemple en or ou en aluminium, pour constituer la partie sensible des jauges.

De plus dans l'invention, les jauges peuvent être identiques (c'est-à-dire avoir la même géométrie et les mêmes matériaux constitutifs avec le même dopage) ou être différentes.

Un dispositif conforme à l'invention peut être fabriqué par une technologie de surface.

Un exemple de procédé de fabrication est schématiquement et partiellement illustré par les figures 8A à 8C.

On commence (figure 8A) par déposer une couche de Ti/Ni/Au sur un substrat SOI comprenant un substrat de base 142 en silicium, une couche sacrificielle 144 en SiO₂, dont l'épaisseur vaut par exemple 0,4 µm, et une couche de silicium 146 dont l'épaisseur vaut par exemple 4 µm. On délimite les contacts du dispositif, tels que le contact 148, par photolithographie et gravure.

On délimite ensuite (figure 8B) la structure mécanique 149 du dispositif par photolithographie et gravure DRIE (pour « Deep Reaction Ion Etching »), avec arrêt sur la couche sacrificielle 144.

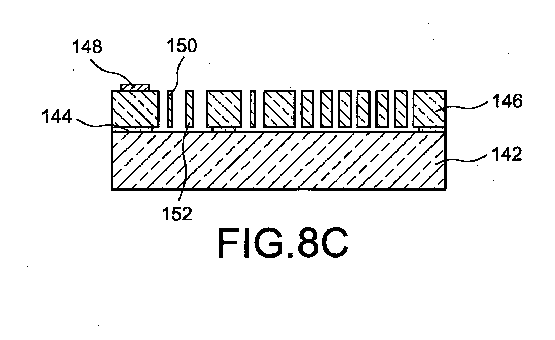

On libère ensuite (figure 8C) les composants du dispositif par exposition à l'acide fluorhydrique (sous forme liquide ou gazeuse), avec arrêt au bout d'une durée déterminée.

On obtient ainsi des jauges piézorésistives telles que la jauge 150, un résonateur 152, et une électrode d'excitation (non représentée) du résonateur.

Dans ce procédé, la photolithographie peut être effectuée au moyen d'un faisceau d'électrons.

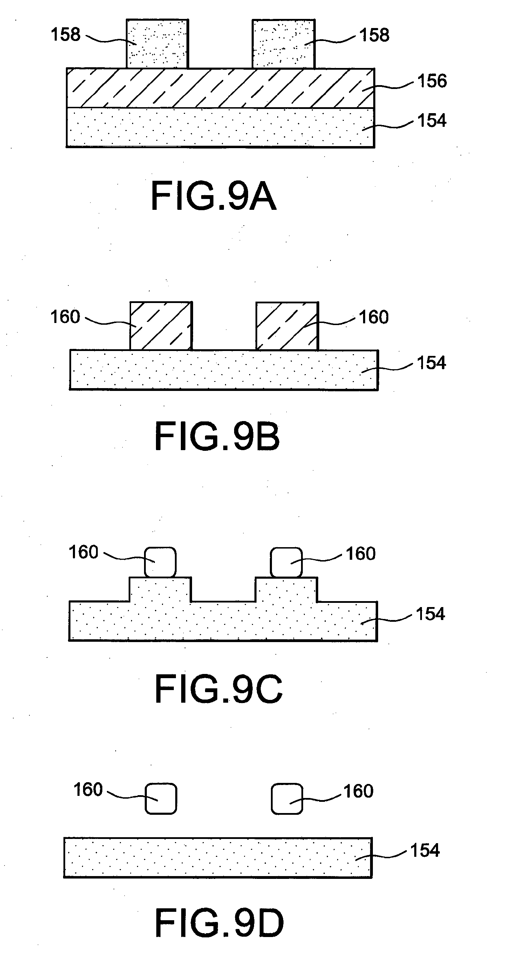

Le résonateur lui-même, mais surtout les jauges piézorésistives, peuvent être des nanofils (en anglais, *nanowires*) que l'on forme par une technologie de surface de type « top-down », conformément à un autre exemple de procédé de fabrication qui est schématiquement illustré par les figures 9A à 9D.

On commence par former une couche sacrificielle 154 (figure 9A) qui peut être en SiO₂, en SiGe ou en Si. On forme ensuite une couche active 156 sur la couche 154.

La couche 156 peut être en Si ou en SiGe. Il s'agit de la couche dans laquelle on forme les divers éléments, ou motifs, du dispositif, tels que la poutre et les jauges piézorésistives.

On forme ensuite un masque de résine photosensible 158 qui est nécessaire à l'obtention des motifs.

On définit ensuite ces motifs, tels que les motifs 160 (figure 9B), par photolithographie et gravure de la couche active. Une réduction de cote de la résine (en anglais, *resist trimming*) peut être effectuée au préalable.

On procède ensuite à une oxydation puis à une désoxydation pour réduire la taille des motifs 160 et les arrondir (figure 9C).

Puis on libère les motifs 160 (figure 9D), à l'aide d'acide fluorhydrique dans le cas de SiO₂ ou à l'aide d'un plasma de type méthane-oxygène dans le cas de SiGe.

## Revendications

1. Dispositif à poutre suspendue et moyens de détection piézorésistive du déplacement de la poutre, le dispositif comprenant :
- un support (14) comportant une surface sensiblement plane,
- une poutre (16 ; 64-66-68) qui est suspendue vis-à-vis du support et apte à se déplacer parallèlement au plan de la surface du support, et
- des moyens (18) de détection du déplacement de la poutre, comprenant au moins deux jauges de contrainte piézorésistives (20,22 ; 40, 42, 44, 46 ; 70, 72, 74, 76 ; 88,90,92,94) sensiblement rectilignes, suspendues vis-à-vis du support, les deux jauges de contrainte n'étant pas dans le prolongement l'une de l'autre,
dans lequel la poutre (16 ;64-66-68) est suspendue vis-à-vis du support (14) par l'intermédiaire des moyens de détection (18) et n'est ainsi pas directement ancrée au support,
**caractérisé en ce que** lesdites au moins deux jauges de contrainte sont respectivement situées sur deux faces latérales opposées de la poutre.

2. Dispositif selon la revendication 1, dans lequel chaque jauge de contrainte comprend un empilement comportant au moins un matériau piézorésistif.

3. Dispositif selon l'une quelconque des revendications 1 et 2, dans lequel la poutre (16 ; 64-66-68) constitue un résonateur et le dispositif comprend en outre des moyens (34) d'actionnement de la poutre.

4. Dispositif selon la revendication 3, dans lequel les moyens (34) d'actionnement de la poutre sont de type électrostatique.

5. Dispositif selon l'une quelconque des revendications 1 à 4, dans lequel la poutre (16) a une section transversale constante.

6. Dispositif selon l'une quelconque des revendications 1 à 4, dans lequel la poutre (64-66-68) a une section transversale non constante.

7. Dispositif selon l'une quelconque des revendications 1 à 6, dans lequel les deux extrémités de la poutre (16) sont aptes à se déplacer parallèlement au plan de la surface du support (14), et les jauges de contrainte (40,42,44,46) sont espacées des deux extrémités de la poutre.

8. Dispositif selon l'une quelconque des revendications 1 à 7, comprenant deux groupes d'au moins deux jauges de contrainte (40-42,44-46 ; 88-92, 90-94), ces deux groupes étant respectivement situés sur deux faces latérales opposées de la poutre (16).

9. Dispositif selon l'une quelconque des revendications 1 à 8, dans lequel au moins l'une (88,90) des jauges de contrainte est élastique.

## Patentansprüche

1. Einrichtung mit aufgehängtem Balken und Mitteln zur piezoresistiven Erfassung der Verlagerung des Balkens, die Einrichtung umfassend:
- einen Träger (14) mit einer im Wesentlichen ebenen Oberfläche,
- einen Balken (16; 64-66-68), der dem Träger gegenüber aufgehängt und dazu geeignet ist, sich parallel zu der Ebene der Oberfläche des Trägers zu verlagern, und
- Erfassungsmittel (18) zur Erfassung der Verlagerung des Balkens, umfassend wenigstens zwei im Wesentlichen rechteckige piezoresistive Dehnungsmessstreifen (20, 22; 40, 42, 44, 46; 70, 72, 74, 76; 88, 90, 92, 94), die dem Träger gegenüber aufgehängt sind, wobei die zwei Dehnungsmessstreifen sich nicht in der Verlängerung zueinander befinden,
wobei der Balken (16; 64-66-68) dem Träger (14) gegenüber vermittels der Erfassungsmittel (18) aufgehängt und so nicht direkt an dem Träger verankert ist,
**dadurch gekennzeichnet, dass** die wenigstens zwei Dehnungsmessstreifen jeweils auf den zwei gegenüberliegenden seitlichen Flächen des Balkens angeordnet sind.

2. Einrichtung nach Anspruch 1, wobei jeder Dehnungsmessstreifen einen Stapel umfasst, welcher wenigstens ein piezoresistives Material umfasst.

3. Einrichtung nach einem der Ansprüche 1 und 2, wobei der Balken (16; 64-66-68) einen Resonator bildet und die Einrichtung weiterhin Mittel (34) zur Betätigung des Balkens umfasst.

4. Einrichtung nach Anspruch 3, wobei die Mittel (34) zur Betätigung des Balkens vom elektrostatischen Typ sind.

5. Einrichtung nach einem der Ansprüche 1 bis 4, wobei der Balken (16) einen konstanten Querschnitt aufinreist.

6. Einrichtung nach einem der Ansprüche 1 bis 4, wobei der Balken (64-66-68) einen nicht-konstanten Querschnitt aufweist.

7. Einrichtung nach einem der Ansprüche 1 bis 6, wobei die zwei Enden des Balkens (16) dazu geeignet sind, sich parallel zu der Ebene der Oberfläche des Trägers (14) zu verlagern, und die Dehnungsmessstreifen (40, 42, 44, 46) von den zwei Enden des Balkens beabstandet sind.

8. Einrichtung nach einem der Ansprüche 1 bis 7, umfassend zwei Gruppen von wenigstens zwei Dehnungsmessstreifen (40-42, 44-46; 88-92, 90-94), wobei die zwei Gruppen jeweils auf den zwei gegenüberliegenden seitlichen Flächen des Balkens (16) angeordnet sind.

9. Einrichtung nach einem der Ansprüche 1 bis 8, wobei wenigstens einer der Dehnungsmessstreifen (88, 90) elastisch ist

## Claims

1. Device with a suspended beam and piezoresistive means of detecting displacement of the beam, the device comprising:
- a support (14) comprising an approximately plane surface,
- a beam (16; 64-66-68) which is suspended from the support and capable of moving parallel to the plane of the surface of the support, and
- means (18) of detecting displacement of the beam, comprising at least two approximately straight piezoresistive strain gauges (20,22; 40,42,44,46; 70,72,74,76; 88,90,92,94) suspended from the support, the two strain gauges not being in line with each other,
in which the beam (16; 64-66-68) is suspended from the support (14) through the detection means (18) and is thus not anchored to the support directly, **characterised in that** said at least two strain gauges are located on two opposite lateral faces of the beam respectively.

2. Device according to claim 1, in which each strain gauge comprises a stack comprising at least one piezoresistive material.

3. Device according to any of claims 1 and 2, in which the beam (16; 64-66-68) forms a resonator and the device also comprises means (34) of actuating the beam.

4. Device according to claim 3, in which the beam actuation means (34) are electrostatic.

5. Device according to any of claims 1 to 4, in which the beam (16) has a constant cross-section.

6. Device according to any of claims 1 to 4, in which the beam (64-66-68) has a variable cross-section.

7. Device according to any of claims 1 to 6, in which the two ends of the beam (16) are capable of moving parallel to the plane of the surface of the support (14), and the strain gauges (40,42,44,46) are at a distance from the two ends of the beam.

8. Device according to any of claims 1 to 7, comprising two groups each containing at least two strain gauges (40-42,44-46; 88-92, 90-94), these two groups being located on two opposite lateral faces of the beam (16) respectively.

9. Device according to any of claims 1 to 8, in which at least one (88,90) of the strain gauges is elastic.
